# EUROPÄISCHE PATENTSCHRIFT

(11) **EP 1 363 306 B1**
(45) Veröffentlichungstag und Bekanntmachung des Hinweises auf die Patenterteilung: **15.04.2015**
(21) Anmeldenummer: 03009869.3
(22) Anmeldetag: 14.05.2003
(51) Int. Cl.: H01H 47/00, F16P 3/00, H03K 17/95, H03K 17/18, H03K 17/945

(54) **Sicherheitsschalter, Sicherheitskreis mit Sicherheitsschaltern und Verfahren zum Betrieb eines Sicherheitsschalters**
Security switch, security circuit with security switches and methode for operating a security switch
Interrupteur de sécurité, circuit de sécurité et procédé de commande d'un interrupteur de sécurité

(30) Priorität: 18.05.2002 DE 10222185; 20.02.2003 DE 10307044
(43) Veröffentlichungstag der Anmeldung: 19.11.2003
(73) Patentinhaber: K.A. SCHMERSAL GmbH & Co., D-42279 Wuppertal (DE)
(72) Erfinder: Hoepken, Hermann, 45549 Sprockhövel (DE); Kienapfel, Udo, 40625 Düsseldorf (DE); Recke, Herbert, 42109 Wuppertal (DE)
(74) Vertreter: Sparing Röhl Henseler

(56) Entgegenhaltungen:
- EP-A- 0 600 311
- EP-A- 1 102 378
- DE-A1- 4 441 070

## Beschreibung

Die Erfindung betrifft einen Sicherheitsschalter nach dem Oberbegriff des Anspruchs 1, einen Sicherheitskreis nach dem Oberbegriff des Anspruchs 5 und ein Verfahren zum Betrieb eines Sicherheitsschalters nach dem Oberbegriff des Anspruchs 9.

Zur Stellungsüberwachung von Schutzgittern, Schutztüren, Maschinenverkleidungsteilen, oder anderen Schutzeinrichtungen, die den Zugang zu rotierenden Maschinenteilen oder anderen Gefahrenstellen sichern, sind in vielen Ländern insbesondere manipulationssichere Sicherheitsschalter gesetzlich vorgeschrieben, die ein Öffnen der Schutzeinrichtung erkennen und Gefährdungen steuerungstechnisch beispielsweise durch Abschalten der Maschine verhindern. Üblicherweise sind die Sicherheitsschalter ortsfest nahe der Schutzeinrichtung angeordnet und werden durch an der Schutzeinrichtung befestigte mechanische, optische, elektronische und/oder induktive Betätiger aktiviert. Hierbei ist möglichst auch bei Stromausfall, Beschädigung der Signalleitungen, Bauteilausfall und anderen Fehlern sicherzustellen, daß eine Gefährdung ausgeschlossen ist. Die Anforderungen an die Widerstandsfähigkeit gegen derartige Fehler sind genormt, vgl. z.B. EN 954-1 oder EN 1088, und führen zu einer Einstufung der Sicherheitsschalter in Sicherheitskategorien.

Aus DE 42 42 792 A1 ist eine Sicherheitsschälteranordnung bekannt, die das sofortige Erkennen von Fehlern in den beiden Hauptschaltern der Anordnung auch bei beliebig lange dauerndem Einschaltzustand gewährleistet. Dazu erhalten die beiden Hauptschalter in relativ kurz aufeinanderfolgenden Zeitabständen ein kurzzeitiges Öffnungssignal, und es wird durch elektronische Überwachungsmittel geprüft, ob die Schalter dadurch tatsächlich geöffnet sind oder nicht.

Aus EP 1 102 378 A2 ist eine Sicherheitsschaltung zur Schaltung einer Last mit Schaltern bekannt, deren Ist-Schaltzustand mit Hilfe von Detektoren durch eine Steuereinheit überwachbar ist.

Aus DE 44 41 070 A1 ist eine Sicherheitsschalteranordnung zum Ein- und Ausschalten der Stromversorgung eines Arbeitsmittels mit Hilfe von Aktoren bekannt. Zur Funktionsüberprüfung der Aktoren werden die Schaltzustände so kurzzeitig geändert, daß sich der Betriebszustand des Arbeitsmittels aufgrund seiner Trägheit nicht ändert.

Zur Prüfung der Funktionsfähigkeit eines Sicherheitsschalters oder mehrerer zu einem Sicherheitskreis in Reihe geschalteter Sicherheitsschalter ist es bekannt, Freigabesignale an einen Eingang des Sicherheitsschalters bzw. ein Ende des Sicherheitskreises anzulegen und an einem Ausgang des Sicherheitsschalters bzw. am anderen Ende des Sicherheitskreises abzugreifen und zur Auswertung zu führen. Eine dynamische Prüfung der einzelnen Sicherheitsschalter ist hierbei nicht möglich, so daß keine hohe Sicherheitskategorie erreichbar ist.

Aus DE 100 11 211 A1 ist ein zum Aufbau eines Sicherheitsschaltgerätesystems in Reihe schaltbares Sicherheitsschaltgerät bekannt.

Der Erfindung liegt deshalb die Aufgabe zugrunde, einen Sicherheitsschalter nach dem Oberbegriff des Anspruchs 1, einen Sicherheitskreis nach dem Oberbegriff des Anspruchs 5 und ein Verfahren zum Betrieb eines Sicherheitsschalters nach dem Oberbegriff des Anspruchs 9 zu schaffen, mit denen eine hohe Sicherheitskategorie erreichbar ist.

Diese Aufgabe wird entsprechend den kennzeichnenden Merkmalen der Ansprüche 1, 5 und 9 gelöst.

Hierdurch wird ein Sicherheitsschalter geschaffen, dessen Komponenten vor und dynamisch während des Betriebs einem Selbsttest unterworfen werden können. Der Selbsttest umfaßt insbesondere eine Überprüfung der Ein- und Ausschaltbarkeit von elektronischen Schaltern im Sicherheitsschalter.

Ferner wird ein Sicherheitskreis aus mehreren über eine Vierdraht-Verbindung verbundenen Sicherheitsschaltern geschaffen, bei dem vor und dynamisch während des Betriebs eine Funktionsprüfung erfolgen kann. Hierbei sind sowohl die selbständige Überprüfung jedes Sicherheitsschalters als auch eine Überprüfung des nachfolgenden Kabelstrangs auf Kurzschluß und Schluß zu einem Fremdpotential gewährleistet.

Wenn der Selbsttest eine Fehlfunktion des Sicherheitsschalters oder des Kabelstrangs des Sicherheitskreises erfaßt, schaltet eine Sicherheitslogik den Sicherheitsschalter in einen sicheren Betriebsmodus um, in welchem seine elektronischen Schalter geöffnet werden und welcher beispielsweise durch Rücksetzen des Sicherheitsschalters, z.B. durch Unterbrechen der Betriebsspannung, wieder verlassen werden kann.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt einen Sicherheitsschalter.
Fig. 2 zeigt einen Sicherheitskreis.
Fig. 3 zeigt eine weitere Ausführungsform eines Sicherheitsschalters.

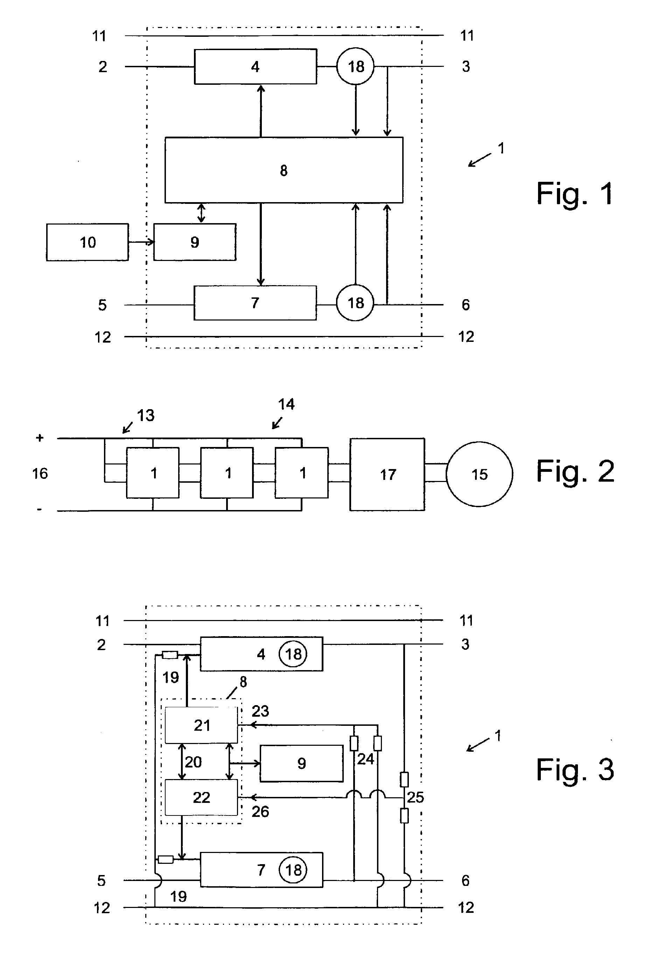

Der in Fig. 1 gezeigte Sicherheitsschalter 1 umfaßt einen zwischen einen Eingangskontakt 2 und einen Ausgangskontakt 3 geschalteten elektronischen Schalter 4, einen zwischen einen Eingangskontakt 5 und einen Ausgangskontakt 6 geschalteten elektronischen Schalter 7, eine mit den elektronischen Schaltern 4, 7 verbundene Steuerung 8 und zumindest einen mit der Steuerung 8 verbundenen beispielsweise mechanischen, elektrischen, optischen und/oder induktiven Sensor 9 für einen entsprechenden Betätiger 10. Hierbei ist ein an die Eingangskontakte 2, 5 anlegbares Freigabesignal bei Erkennen des Betätigers 10 durch die Steuerung 8 durch Schließen der elektrischen Schalter 4, 7 an die jeweiligen Ausgangskontakte 3, 6 durchschaltbar. Die Energieversorgung der elektronischen Komponenten des Sicherheitsschalters 1 erfolgt über durchgeschleifte Anschlüsse 11, 12 für eine Betriebsspannung bzw. Masse.

Mehrere Sicherheitsschalter 1 sind wie in Fig. 2 gezeigt über eine Vierdraht-Verbindung 13 zu einem Sicherheitskreis 14 für eine Einrichtung 15 mit Gefahrpotential verbindbar.

Dabei sind die beiden in der Fig. 2 äußeren Adern der Vierdraht-Verbindung 13 an eine Spannungsquelle 16 gekoppelt und liefern über die Anschlüsse 11 und 12 die Betriebsspannung bzw. Masse an jeden der Sicherheitsschalter 1. Die Betriebsspannung wird zudem als Freigabesignal den beiden Eingangskontakten 2, 5 des ersten, in der Fig. 2 linken Sicherheitsschalters 1 des Sicherheitskreises 14 zugeführt.

Die anderen beiden Adern der Vierdraht-Verbindung 13 dienen der Weiterleitung des Freigabesignals entlang des Sicherheitskreises 14, wobei die Eingangskontakte 2, 5 des zweiten und jedes weiteren Sicherheitsschalters 1 mit den Ausgangskontakten 3, 6 des jeweils vorhergehenden Sicherheitsschalters 1 und die Ausgangskontakte 3, 6 des letzten, in der Fig. 2 rechten Sicherheitsschalters 1 über eine Auswerteeinrichtung 17 mit der Einrichtung 15 verbunden sind.

Wenn beide an den Ausgangskontakten 3, 6 des letzten Sicherheitsschalters 1 anliegenden Pegel Einschaltbedingungen erreichen, signalisiert die Auswerteeinrichtung 17 beispielsweise einer hier integrierten Steuerung mit einem Leistungsschalter, daß alle Sicherheitseinrichtungen geschlossen sind und die Einrichtung 15, beispielsweise ein Motor, gefahrlos in Betrieb genommen werden kann.

Jeder Sicherheitsschalter 1 wird bei erstmaliger Inbetriebnahme, d.h. nach dem Anlegen der Betriebsspannung an die Anschlüsse 11, 12, einem Anlaufselbsttest unterworfen.

Die Prüfung beginnt bei dem ersten Sicherheitsschalter 1 des Sicherheitskreises 14. Die Steuerung 8 überwacht kontinuierlich den Sensor 9 und schaltet, sobald ein zugehörige Betätiger 10 erkannt wird, die beiden elektronischen Schalter 4, 7 ein. Die Steuerung 8 überprüft danach, ob an den Eingangskontakten 2, 5 das Freigabesignal, hier die Betriebsspannung, anliegt.
Dies erfolgt für den Eingangskontakt 2 (5) durch Erfassen der Spannung am Ausgangskontakt 3 (6). Hierzu kann ein digitaler Eingang der Steuerung 8 mit dem Ausgangskontakt 3 (6) und über einen Pull-Down-Widerstand mit Masse verbunden sein, so daß eine logische 1 anliegt, wenn das Freigabesignal vorhanden ist, und eine logische 0 anliegt, wenn es nicht vorhanden ist.

Unterscheidet sich die an den Ausgangskontakten 3, 6 erfaßte Spannung, deutet dies auf eine Fehlfunktion hin. Ursache hierfür können ein Schluß eines der Ausgangskontakte 3, 6 oder eines daran angeschlossenen Kabelstrangs zu einem Fremdpotential oder auf eine das korrekte Schließen verhindernde Fehlfunktion eines der elektronischen Schalter 4, 7 bzw. der Steuerung 8 sein. In diesem Fall schaltet eine hier als Programm in die Steuerung 8 integrierte Sicherheitslogik den Sicherheitsschalter 1 in einen sicheren Betriebsmodus um, in welchem beide elektronischen Schalter 4, 7 geöffnet werden und welcher beispielsweise nur nach einem Rücksetzen des Sicherheitsschalters 1 beendet werden kann

Sobald das Freigabesignal korrekt an den Ausgangskontakten 3, 6 erkannt ist, wird der Anlaufselbsttest mit der Überprüfung fortgesetzt, ob der zugehörige elektronische Schalter 4, 7 ordnungsgemäß geöffnet werden kann. Hierzu veranlaßt die Steuerung 8 sein Öffnen und erfaßt wie vorstehend beschrieben die Spannung am jeweiligen Ausgangskontakt 3, 6. Fällt die Spannung nicht auf 0V ab, deutet dies auf einen Schluß des zugehörigen Ausgangskontakts 3, 6 oder eines daran angeschlossenen Kabelstrangs zur Betriebsspannung oder zu einem Fremdpotential oder auf eine das vollständige Öffnen verhindernde Fehlfunktion des elektronischen Schalters 4, 7 bzw. der Steuerung 8 hin. In diesem Fall wird in den sicheren Betriebsmodus umgeschaltet.

Der Anlaufselbsttest des ersten Sicherheitsschalters 1 ist nunmehr abgeschlossen und der Sicherheitsschalter 1 ist in Betrieb.

Damit ist das Freigabesignal an den nächsten Sicherheitsschalter 1 im Sicherheitskreis 14 durchgeschaltet. Dieser kann daraufhin den gleichen Anlaufselbsttest durchlaufen. Bei Aktivierung durch einen zugeordneten Betätiger wird das Freigabesignal an den nachfolgenden Sicherheitsschalter durchgeschaltet. So durchlaufen nacheinander alle Sicherheitsschalter 1 des Sicherheitskreises 14 den Anlaufselbsttest.

Während des Betriebs der Sicherheitsschalter 1 werden dynamische Selbsttests durchgeführt.

Zum einen werden die beiden elektronischen Schalter 4, 7 während des Betriebs durch die Steuerung 8 insbesondere nacheinander jeweils für kurze Zeit deaktiviert und dabei ihr Schaltzustand überwacht, um zu überprüfen, ob die elektronischen Schalter 4, 7 noch abschaltbar sind und ob zwischenzeitlich ein Schluß zu einem Fremdpotential vorliegt. Bei Vorliegen eines Fehlers wird in den sicheren Betriebsmodus umgeschaltet. Die Zeitspanne ist so kurz zu wählen, daß die mit den Ausgangskontakten 3, 6 verbundenen weiteren Sicherheitsschalter 1 durch die Unterbrechung der Betriebsspannung nicht beeinträchtigt werden.

Zum anderen wird der Strom durch beide elektronischen Schalter 4, 7 überwacht. Hierzu ist den elektronischen Schaltern 4, 7 jeweils ein Überwachungsschaltkreis 18 zum Überwachen des den elektronischen Schalter 4 bzw. 7 durchfließenden Stroms zugeordnet. Die Überwachungsschaltkreise 18 können im einfachsten Fall als zweckmäßigerweise rücksetzbare Sicherungen ausgestaltet sein. Liegt der Strom über einem Schwellenwert, deutet dies auf einen Kurzschluß zwischen den Ausgangskontakten 3, 6 oder im nachfolgenden Kabelstrang hin und der Sicherheitsschalter 1 schaltet in den sicheren Betriebsmodus um.

Somit werden die elektronischen Schalter 4, 7 und der nachfolgende Kabelstrang während des Betriebs dynamisch auf Kurzschluß, Schluß zu einem Fremdpotential und Abschalt- und Schließbarkeit überprüft.

Während des Betriebs überwacht die Steuerung 8 jedes Sicherheitsschalters 1 im Sicherheitskreis 14 kontinuierlich ihren Sensor 9. Ist einer der Betätiger 10 infolge Öffnens der zugehörigen Sicherheitseinrichtung nicht mehr durch den zugeordneten Sensor 9 des zugeordneten Sicherheitsschalters 1 detektierbar, werden dessen elektronische Schalter 4, 7 geöffnet. Das korrekte Öffnen wird zweckmäßigerweise wie vorstehend für den Anlaufselbsttest beschrieben überwacht. Die im Sicherheitskreis 14 nachfolgenden Sicherheitsschalter 1 erkennen den Wegfall des Freigabesignals und unterbrechen die dynamische Prüfung ihrer jeweiligen elektronischen Schalter 4, 7, ohne deren Schaltzustand zu verändern, bis das Freigabesignal erneut anliegt. Die Auswerteeinrichtung 17 trifft die erforderlichen Maßnahmen, schaltet z.B. die Einrichtung 15 ab.

Wird die Sicherheitseinrichtung wieder geschlossen und der Betätiger 10 daraufhin wieder erkannt, veranlaßt die Steuerung 8, daß die beiden elektronischen Schalter 4, 7 wieder geschlossen werden. Das ordnungsgemäße Schließen wird dabei wie vorstehend für den Anlaufselbsttest beschrieben überprüft, bevor zur dynamischen Prüfung übergangen wird. Die im Sicherheitskreis 14 nachfolgenden Sicherheitsschalter 1 erkennen nacheinander das Freigabesignal und nehmen ihre dynamische Prüfung ebenfalls wieder auf. Der Anlaufselbsttest ist nicht erforderlich. Die Auswerteeinrichtung 17 erkennt, daß die Einrichtung 15 wieder gefahrlos angeschaltet werden kann.

Die elektronischen Schalter 4, 7 werden vorzugsweise als Halbleiter ausgestaltet, z.B. als MOSFET-Leistungstransistoren, deren Source und Drain mit den Eingangs- und Ausgangskontakten 2, 5, 3, 6 und deren Gate mit der Steuerung 8 verbunden ist.

Im in Fig. 3 gezeigten Sicherheitsschalter 1 ist beispielhaft der elektronischer Schalter 4 zusammen mit dem Überwachungsschaltkreis 18 als MOSFET-Leistungstreiber mit Strombegrenzung, wie er z.B. von der Firma STMicroelectronics unter der Bezeichnung VN750 erhältlich ist, und der elektronischer Schalter 7 zusammen mit einem weiteren Überwachungsschaltkreis 18 durch einen MOSFET-Leistungsschalter mit Strombegrenzung, wie er z.B. von der Firma International Rectifier unter der Bezeichnung IPS031G erhältlich ist, ausgestaltet.

Die Steuereingänge der MOSFETs sind über jeweils einen Pull-Down-Widerstand 19 mit Masse sowie mit Steuerausgängen der Steuerung 8 verbunden, die hier zweikanalig ausgeführt ist und zwei über eine Verbindung 20 zur gegenseitigen Funktionsüberprüfung miteinander gekoppelte Mikrocontroller 21, 22, z.B. vom Typ ATtiny15L, umfaßt.

Der Mikrocontroller 21 steuert den elektronischen Schalter 4 und überwacht den Schaltzustand des elektronischen Schalters 7. Hierzu ist der Ausgang des elektronischen Schalters 7 über zwei Widerstände 24 an einen Eingang 23 des Mikrocontrollers 21 sowie Masse gekoppelt.

Der Mikrocontroller 22 steuert den elektronischer Schalter 7 und überwacht den Schaltzustand des elektronischer Schalters 4. Hierzu ist der Ausgang des elektronischen Schalters 4 über zwei Widerstände 25 an einen Eingang 26 des Mikrocontrollers 22 sowie Masse gekoppelt.

## Patentansprüche

1. Sicherheitsschalter mit zwei zwischen jeweils einen Eingangskontakt (2, 5) für ein Freigabesignal und jeweils einen Ausgangskontakt (3, 6) geschalteten elektronischen Schaltern (4, 7), einem Sensor (9) für einen Betätiger (10), einer Steuerung (8) zum Aktivieren der elektronischen Schalter (4, 7) in Reaktion auf eine Betätigung des Sensors (9), die an die Ausgangskontakte (3, 6) zum Erkennen von mit dem Schaltzustand unvereinbaren Signalen an den Ausgangskontakten (3, 6) gekoppelt ist, und eine Sicherheitslogik zum Abschalten der elektronischen Schalter (4, 7) bei einer Fehlfunktion, wobei die Energieversorgung der elektronischen Komponenten des Sicherheitsschalters (1) über durchgeschleifte Anschlüsse (11, 12) für eine Betriebsspannung bzw. Masse erfolgt, jeder Sicherheitsschalter (1) nach dem Anlegen der Betriebsspannung an die Anschlüsse (11, 12), einem Anlaufselbsttest unterworfen wird, wobei für den Anlaufselbsttest die Steuerung (8) zum Erfassen der Spannung an den Ausgangskontakten (3, 6) bei geöffneten elektronischen Schaltern (4, 7) ausgelegt ist, für dynamische Selbsttests die während des Betriebs der Sicherheitsschalter (1) durchgeführt werden, die Steuerung (8) den durch die elektronischen Schalter (4, 7) fließenden Strom über jeweils einen Überwachungsschaltkreis (18) erfasst, wozu die Steuerung (8) zum zyklischen kurzzeitigen Öffnen der elektronischen Schalter (4, 7) ausgestaltet ist, **dadurch gekennzeichnet dass** bei den Anlaufselbsttest, die Spannung auch bei geschlossenen elektronischen Schaltern erfasst wird; das Freigabesignal auf die Ausgangskontakte durchschaltbar ist, und für eine Anschließbarkeit der Ausgangskontakte (3, 6) an Eingangskontakte eines zweiten Sicherheitsschalters (1) in einem Sicherheitskreis (14) die Steuerung (8) die Spannungen an den Ausgangskontakten (3, 6) auf das Anliegen des Freigabesignals hin überprüft; und dass während der dynamischen Selbsttests die Öffnungszeiten der elektronischen Schalter (4, 7) so kurz zu wählen sind, dass die mit den Ausgangskontakten (3, 6) verbundenen weiteren Sicherheitsschalter (1) durch die Unterbrechung der Betriebsspannung nicht beeinträchtigt werden.

2. Sicherheitsschalter nach Anspruch 1, **dadurch gekennzeichnet, dass** die Überwachungsschaltkreise (18) als rücksetzbare Sicherungen ausgestaltet sind.

3. Sicherheitsschalter nach Anspruch 1 oder 2, **dadurch gekennzeichnet, daß** die Steuerung (8) und die Sicherheitslogik zwei einander überwachende Mikroprozessoren oder Mikrocontroller (21, 22) umfaßt.

4. Sicherheitsschalter nach einem der Ansprüche 1 bis 3, **dadurch gekennzeichnet, daß** die elektronischen Schalter (4, 7) Transistoren sind.

5. Sicherheitskreis für eine Einrichtung (15) mit Gefahrpotential, umfassend eine Anzahl in Reihe geschalteter Sicherheitsschalter nach einem der Ansprüche 1 bis 4, **dadurch gekennzeichnet, daß** die Eingangskontakte (2, 5) des ersten Sicherheitsschalters (1) mit einem Freigabesignal beaufschlagbar sind, die Eingangskontakte (2, 5) jedes nachfolgenden Sicherheitsschalters (1) mit den Ausgangskontakten (3, 6) des vorhergehenden Sicherheitsschalters (1) und die Ausgangskontakte (3, 6) des letzten Sicherheitsschalters (1) über eine Auswerteeinrichtung (17) mit der Einrichtung (15) gekoppelt sind.

6. Sicherheitskreis nach Anspruch 5, **dadurch gekennzeichnet, dass** die Steuerung (8) jedes der Sicherheitsschalter (1) kontinuierlich ihren Sensor (9) überwacht und das Öffnen der elektronischen Schalter (4, 7) eines Sicherheitsschalters (1) den dynamischen Selbsttest der nachfolgenden Sicherheitsschalter (1) unterbricht.

7. Sicherheitskreis nach Anspruch 6, **dadurch gekennzeichnet, dass** die Auswerteeinrichtung (17) die Einrichtung (15) schaltet.

8. Sicherheitskreis nach Anspruch 7, **dadurch gekennzeichnet, dass** die Auswerteeinrichtung (17) schaltet, wenn der am letzten Sicherheitsschalter (1) anliegende Pegel Einschaltbedingungen erreicht.

9. Verfahren zum Betrieb eines Sicherheitsschalters (1) nach Anspruch 1 mit zwei zwischen jeweils einen Eingangskontakt (2, 5) für ein Freigabesignal und jeweils einen Ausgangskontakt (3, 6) geschalteten elektronischen Schaltern (4, 7), einem Sensor (9) für einen Betätiger (10), einer Steuerung (8), die die elektronischen Schalter (4, 7) in Reaktion auf eine Betätigung des Sensors (9) aktiviert und die an die Ausgangskontakte (3, 6) zum Erkennen von mit dem Schaltzustand unvereinbaren Signalen an den Ausgangskontakten (3, 6) gekoppelt ist, und eine Sicherheitslogik, die die elektronischen Schalter (4, 7) bei einer Fehlfunktion abschaltet, wobei die Energieversorgung der elektronischen Komponenten des Sicherheitsschalters (1) über durchgeschleifte Anschlüsse (11, 12) für eine Betriebsspannung bzw. Masse erfolgt , jeder Sicherheitsschalter (1) nach dem Anlegen der Betriebsspannung an die Anschlüsse (11, 12), einem Anlaufselbsttest unterworfen wird, wobei die Steuerung (8) bei einem Anlaufselbsttest die Spannung an den Ausgangskontakten (3, 6) bei geöffneten elektronischen Schaltern (4, 7) erfasst, und die Steuerung (8) bei dynamischen Selbsttests, die während des Betriebs der Sicherheitsschalter (1) durchgeführt werden, den durch die elektronischen Schalter (4, 7) fließenden Strom über jeweils einen Überwachungsschaltkreis (18) erfasst, wozu die Steuerung (8) die elektronischen Schalter (4, 7) zyklisch kurzzeitig öffnet , **dadurch gekennzeichnet, dass** bei den Anlaufselbsttest, die Spannung auch bei geschlossenen elektronischen Schaltern erfasst wird; das Freigabesignal auf die Ausgangskontakte durchschaltbar ist, und die Steuerung (8) die Spannungen an den Ausgangskontakten (3, 6) auf das Anliegen des Freigabesignals hin überprüft und dass die Ausgangskontakte (5, 6) das Freigabesignal für einen in einem Sicherheitskreis (14) nachfolgend anschließbaren Sicherheitsschalter (1) bereitstellen, und dass während der dynamischen Selbsttests die Öffnungszeiten der elektronischen Schalter (4, 7) so kurz zu wählen sind, dass die mit den Ausgangskontakten (3, 6) verbundenen weiteren Sicherheitsschalter (1) durch die Unterbrechung der Betriebsspannung nicht beeinträchtigt werden.

10. Verfahren nach Anspruch 9, **dadurch gekennzeichnet, daß** der Stromfluß durch wenigstens einen der elektronischen Schalter (4, 7) überwacht wird und bei Überschreiten eines Schwellenwertes der Sicherheitszustand aktiviert wird.

11. Verfahren nach Anspruch 9 oder 10, **dadurch gekennzeichnet, daß** die Schließbarkeit der elektronischen Schalter (4, 7) aus dem geöffneten Zustand überprüft wird.

12. Verfahren nach einem der Ansprüche 9 bis 11, **dadurch gekennzeichnet, daß** die Schließbarkeit eines der elektronischen Schalter (4) aus dem geöffneten Zustand überprüft wird, während der jeweils andere (7) geöffnet ist.

13. Verfahren nach einem der Ansprüche 9 bis 12, **dadurch gekennzeichnet, daß** die Ausschaltbarkeit der elektronischen Schalter (4, 7) aus dem geschlossenen Zustand zyklisch überprüft wird.

14. Verfahren nach einem der Ansprüche 9 bis 13, **dadurch gekennzeichnet, daß** die Ausschaltbarkeit eines der elektronischen Schalter (4) aus dem geschlossenen Zustand überprüft wird, während der jeweils andere (7) geschlossen ist.

15. Verfahren nach einem der Ansprüche 9 bis 14, **dadurch gekennzeichnet, daß** die elektronischen Schalter (4, 7) im Sicherheitszustand geöffnet werden.

## Claims

1. Safety switch having two electronic switches (4, 7) each connected between an input contact (2, 5) for an enable signal and an output contact (3, 6), a sensor (9) for an actuator (10), a controller (8) for activating the electronic switches (4, 7) in response to actuation of the sensor (9), which controller is coupled to the output contacts (3, 6) for the purpose of detecting signals which are incompatible with the switching state at the output contacts (3, 6), and safety logic for switching off the electronic switches (4, 7) in the event of a malfunction, the electronic components of the safety switch (1) being supplied with energy via looped-through connections (11, 12) for an operating voltage or earth, and each safety switch (1) being subjected to a start-up self-test after the operating voltage has been applied to the connections (11, 12), in which case, for the start-up self-test, the controller (8) is designed to detect the voltage at the output contacts (3, 6) when the electronic switches (4, 7) are open and, for dynamic self-tests which are carried out during operation of the safety switches (1), the controller (8) detects the current flowing through the electronic switches (4, 7) using a respective monitoring circuit (18), for which purpose the controller (8) is designed to cyclically briefly open the electronic switches (4, 7), **characterized in that**, during the start-up self-test, the voltage is also detected when the electronic switches are closed; the enable signal can be switched through to the output contacts, and, in order to be able to connect the output contacts (3, 6) to input contacts of a second safety switch (1) in a safety circuit (14), the controller (8) checks the voltages at the output contacts (3, 6) for the presence of the enable signal; and **in that**, during the dynamic self-tests, the opening times of the electronic switches (4, 7) should be selected to be so short that the further safety switches (1) connected to the output contacts (3, 6) are not impaired by the interruption in the operating voltage.

2. Safety switch according to Claim 1, **characterized in that** the monitoring circuits (18) are in the form of resettable fuses.

3. Safety switch according to Claim 1 or 2, **characterized in that** the controller (8) and the safety logic comprise two microprocessors or microcontrollers (21, 22) which monitor one another.

4. Safety switch according to one of Claims 1 to 3, **characterized in that** the electronic switches (4, 7) are transistors.

5. Safety circuit for a device (15) with a hazard potential, comprising a number of safety switches according to one of Claims 1 to 4 which are connected in series, **characterized in that** an enable signal can be applied to the input contacts (2, 5) of the first safety switch (1), the input contacts (2, 5) of each subsequent safety switch (1) are coupled to the output contacts (3, 6) of the preceding safety switch (1), and the output contacts (3, 6) of the last safety switch (1) are coupled to the device (15) via an evaluation device (17).

6. Safety circuit according to Claim 5, **characterized in that** the controller (8) of each of the safety switches (1) continuously monitors its sensor (9) and the opening of the electronic switches (4, 7) of a safety switch (1) interrupts the dynamic self-test of the subsequent safety switches (1).

7. Safety circuit according to Claim 6, **characterized in that** the evaluation device (17) switches the device (15).

8. Safety circuit according to Claim 7, **characterized in that** the evaluation device (17) switches when the level applied to the last safety switch (1) reaches switch-on conditions.

9. Method for operating a safety switch (1) according to Claim 1 having two electronic switches (4, 7) each connected between an input contact (2, 5) for an enable signal and an output contact (3, 6), a sensor (9) for an actuator (10), a controller (8) which activates the electronic switches (4, 7) in response to actuation of the sensor (9) and is coupled to the output contacts (3, 6) for the purpose of detecting signals which are incompatible with the switching state at the output contacts (3, 6), and safety logic which switches off the electronic switches (4, 7) in the event of a malfunction, the electronic components of the safety switch (1) being supplied with energy via looped-through connections (11, 12) for an operating voltage or earth, and each safety switch (1) being subjected to a start-up self-test after the operating voltage has been applied to the connections (11, 12), in which case, during a start-up self-test, the controller (8) detects the voltage at the output contacts (3, 6) when the electronic switches (4, 7) are open, and, during dynamic self-tests which are carried out during operation of the safety switches (1), the controller (8) detects the current flowing through the electronic switches (4, 7) using a respective monitoring circuit (18), for which purpose the controller (8) cyclically briefly opens the electronic switches (4, 7), **characterized in that**, during the start-up self-test, the voltage is also detected when the electronic switches are closed; the enable signal can be switched through to the output contacts, and the controller (8) checks the voltages at the output contacts (3, 6) for the presence of the enable signal, and **in that** the output contacts (5, 6) provide the enable signal for a safety switch (1) which can be subsequently connected in a safety circuit (14), and **in that**, during the dynamic self-tests, the opening times of the electronic switches (4, 7) should be selected to be so short that the further safety switches (1) connected to the output contacts (3, 6) are not impaired by the interruption in the operating voltage.

10. Method according to Claim 9, **characterized in that** the current flow through at least one of the electronic switches (4, 7) is monitored, and the safety state is activated when a threshold value is exceeded.

11. Method according to Claim 9 or 10, **characterized in that** the ability to close the electronic switches (4, 7) from the open state is checked.

12. Method according to one of Claims 9 to 11, **characterized in that** the ability to close one of the electronic switches (4) from the open state is checked while the respective other switch (7) is open.

13. Method according to one of Claims 9 to 12, **characterized in that** the ability to switch off the electronic switches (4, 7) from the closed state is cyclically checked.

14. Method according to one of Claims 9 to 13, **characterized in that** the ability to switch off one of the electronic switches (4) from the closed state is checked while the respective other switch (7) is closed.

15. Method according to one of Claims 9 to 14, **characterized in that** the electronic switches (4, 7) are opened in the safety state.

## Revendications

1. Interrupteur de sécurité comportant deux interrupteurs électroniques (4; 7) connectés chacun entre un contact d'entrée (2 ; 5) pour un signal de validation et un contact de sortie (3 ; 6), et comportant un capteur (9) pour un actionneur (10), et une commande (8) pour l'activation desdits interrupteurs électroniques (4 ; 7) en réponse à un actionnement dudit capteur (9), et qui est couplée auxdits contacts de sortie (3 ; 6) pour la détection, au niveau desdits contacts de sortie (3 ; 6), de signaux dans des états de commutation incompatibles entre eux, et comportant une logique de sécurité pour la déconnexion desdits interrupteurs électroniques (4 ; 7) en cas de défaillance, où l'alimentation en énergie des composants électroniques dudit interrupteur de sécurité (1) est effectuée par une boucle sur des raccordements (11 ; 12) pour l'obtention d'une tension de service ou bien d'une masse, où chaque dit interrupteur de sécurité (1) est soumis à un auto-test de démarrage après l'application de la tension de service auxdits raccordements (11 ; 12), et où, pour ledit auto-test de démarrage, ladite commande (8) est configurée pour la détection de la tension auxdits contacts de sortie (3 ; 6) quand lesdits interrupteurs électroniques (4 ; 7) sont ouverts, pour des auto-tests dynamiques pendant le fonctionnement dudit interrupteur de sécurité (1), ladite commande (8) détecte du courant circulant au travers desdits interrupteurs électroniques (4 ; 7) au moyen, pour chacun, d'un circuit de commutation de surveillance (18), et qu'à cet effet la dite commande (8) est configurée pour l'ouverture cyclique et de courte durée desdits interrupteurs électroniques (4 ; 7), **caractérisé en ce que**, lors dudit auto-test de démarrage, la tension est aussi détectée quand lesdits interrupteurs électroniques sont fermés, que le signal de validation est commutable sur les contacts de sortie, et **en ce que**, pour permettre une connexion desdits contacts de sortie (3 ; 6) aux contacts d'entrée d'un deuxième interrupteur de sécurité (1) dans un circuit de sécurité (14), ladite commande (8) vérifie les tensions auxdits contacts de sortie (3 ; 6) sur la base dudit signal de validation, et **en ce que**, pendant ledit auto-test dynamique, les temps d'ouverture desdits interrupteurs électroniques (4 ; 7) sont choisis assez brefs pour que d'autres interrupteurs de sécurité (1) liés auxdits contacts de sortie (3 ; 6) ne soient pas influencés par l'interruption de la tension de service.

2. Interrupteur de sécurité selon la revendication 1, **caractérisé en ce que** lesdits circuits de commutation de surveillance (18) sont agencés en tant que sécurités réinitialisables.

3. Interrupteur de sécurité selon la revendication 1 ou 2, **caractérisé en ce que** ladite commande (8) et ladite logique de sécurité comportent deux microprocesseurs ou microcontrôleurs (21 ; 22) se surveillant mutuellement.

4. Interrupteur de sécurité selon l'une des revendications 1 à 3, **caractérisé en ce que** lesdits interrupteurs électroniques (4 ; 7) sont des transistors.

5. Circuit de sécurité pour un dispositif (15) potentiellement dangereux, comportant une pluralité de dits interrupteurs de sécurité selon l'une des revendications 1 à 4 agencés en série, **caractérisé en ce que** lesdits contacts d'entrée (2 ; 5) du premier dit interrupteur de sécurité (1) sont alimentables avec un signal de validation, et que lesdits contacts d'entrée (2 ; 5) de chaque dit interrupteur de sécurité (1) suivant sont couplés avec lesdits contacts de sortie (3 ; 6) de chaque dit interrupteur de sécurité (1) précédent, et que lesdits contacts de sortie (3, 6) dudit dernier interrupteur de sécurité (1) sont couplés avec ledit dispositif (15) par l'intermédiaire d'un dispositif d'évaluation (17).

6. Circuit de sécurité selon la revendication 5, **caractérisé en ce que** ladite commande (8) de chaque dit interrupteur de sécurité (1) surveille son dit capteur (9) en continu, et **en ce que** l'ouverture desdits interrupteurs électroniques (4 ; 7) d'un dit interrupteur de sécurité (1) interrompt ledit auto-test dynamique desdits interrupteurs de sécurité (1) suivant.

7. Circuit de sécurité selon la revendication 6, **caractérisé en ce que** ledit dispositif d'évaluation (17) commute ledit dispositif (15).

8. Circuit de sécurité selon la revendication 7, **caractérisé en ce que** ledit dispositif d'évaluation (17) commute lorsque, au niveau dudit dernier interrupteur de sécurité (1), le niveau atteint des conditions de commutation.

9. Procédé de commande d'un interrupteur de sécurité (1) selon la revendication 1 comportant deux interrupteurs électroniques (4 ; 7) connectés chacun entre un contact d'entrée (2 ; 5) pour un signal de validation et un contact de sortie (3 ; 6), et comportant un capteur (9) pour un actionneur **(10),** une commande (8) qui active lesdits interrupteurs électroniques (4 ; 7) en réponse à un actionnement dudit capteur (9) et qui est couplée auxdits contacts de sortie (3 ; 6) pour la détection, au niveau desdits contacts de sortie (3 ; 6), de signaux dans des états de commutation incompatibles entre eux, et comportant une logique de sécurité, qui déconnecte lesdits interrupteurs électroniques (4 ; 7) en cas de défaillance, où l'alimentation en énergie des composants électroniques dudit interrupteur de sécurité (1) est effectuée par une boucle sur des raccordements (11 ; 12) pour l'obtention d'une tension de service ou bien d'une masse, où chaque dit interrupteur de sécurité (1) est soumis à un auto-test de démarrage après l'application de la tension de service auxdits raccordements (11 ; 12), et où ladite commande (8) détecte, lors d'un dit auto-test de démarrage, la tension auxdits contacts de sortie (3 ; 6) quand lesdits interrupteurs électroniques (4 ; 7) sont ouverts, et où lors desdits auto-tests dynamiques, qui sont conduits pendant le fonctionnement dudit interrupteur de sécurité (1), ladite commande (8) détecte du courant circulant au travers desdits interrupteurs électroniques (4 ; 7) au moyen, pour chacun, d'un circuit de commutation de surveillance (18), et qu'à cet effet la dite commande (8) ouvre cycliquement, et pour une courte durée, lesdits interrupteurs électroniques (4 ; 7), **caractérisé en ce que**, lors dudit auto-test de démarrage, la tension est aussi détectée au niveau desdits interrupteurs électroniques fermés, et le signal de validation est commutable sur lesdits contacts de sortie, et ladite commande (8) vérifie les tensions auxdits contacts de sortie (3 ; 6) sur la base dudit signal de validation, et **en ce que** lesdits contacts de sortie (3 ; 6) tiennent à disposition ledit signal de validation pour un dit interrupteur de sécurité (1) connectable en aval dans un circuit de sécurité (14), et **en ce que**, pendant ledit auto-test dynamique, les temps d'ouverture desdits interrupteurs électroniques (4 ; 7) sont choisis assez brefs pour que d'autres interrupteurs de sécurité (1) liés auxdits contacts de sortie (3 ; 6) ne soient pas influencés par l'interruption de la tension de service.

10. Procédé selon la revendication 9, **caractérisé en ce qu'**on surveille le flux de courant au travers d'au moins un dit interrupteur électronique (4 ; 7), et qu'on active l'état de sécurité lors du dépassement d'une valeur de seuil.

11. Procédé selon la revendication 9 ou 10, **caractérisé en ce qu'**on vérifie la capacité de fermeture desdits interrupteurs électroniques (4 ; 7) depuis leur état d'ouverture.

12. Procédé selon l'une des revendications 9 à 11, **caractérisé en ce qu'**on vérifie la capacité de fermeture d'un (4) desdits interrupteurs électroniques depuis son état d'ouverture, pendant que l'autre (7) est ouvert.

13. Procédé selon l'une des revendications 9 à 12, **caractérisé en ce qu'**on vérifie de façon cyclique la capacité d'ouverture desdits interrupteurs électroniques (4 ; 7) depuis leur état de fermeture.

14. Procédé selon l'une des revendications 9 à 13, **caractérisé en ce qu'**on vérifie la capacité d'ouverture d'un (4) desdits interrupteurs électroniques depuis son état de fermeture, pendant que l'autre (7) est fermé.

15. Procédé selon l'une des revendications 9 à 14, **caractérisé en ce que**, dans un état de sécurité, lesdits interrupteurs électroniques (4 ; 7) sont ouverts.
